# DEMANDE DE BREVET EUROPEEN

(11) **EP 3 869 409 A1**
(43) Date de publication de la demande: **25.08.2021**
(21) Numéro de dépôt: 21158480.0
(22) Date de dépôt: 20.02.2015
(51) Int. Cl.: G06K 19/077

(54) **PROCÉDÉ DE FABRICATION D'UN MODULE ÉLECTRONIQUE SIMPLE FACE COMPRENANT DES ZONES D'INTERCONNEXION**

(62) Demande divisionnaire de: 15305271.7
(71) Demandeur: Thales DIS France SA, 92190 Meudon (FR)
(72) Inventeur: OTTOBON, Stéphane, 13881 Gémenos Cedex (FR); DOSSETTO, Lucile, 13881 Gémenos Cedex (FR); CHARLES, Luc, 13881 Gémenos Cedex (FR); LAVIRON, Thierry, 13881 Gémenos Cedex (FR)
(74) Mandataire: Grevin, Emmanuel

(57) **Abrégé**

L'invention concerne un procédé de fabrication d'un module (17) à puce électronique comprenant des métallisations accessibles d'un premier côté des métallisations et une puce de circuit intégré disposée du second côté des métallisations, opposé au premier côté ; Le procédé est caractérisé en ce qu'il comprend l'étape de formation d'éléments d'interconnexion électrique (9C, 19C, 30), distincts des métallisations, reliant directement la puce et disposés du second côté des métallisations.

L'invention concerne également un module correspondant au procédé et dispositif le comportant.

## Description

### Domaine de l'invention.

L'invention concerne un procédé de fabrication d'un module à puce électronique comprenant des métallisations (ou plages de contact électrique) accessibles d'un premier côté des métallisations et une puce de circuit intégré disposée du second côté des métallisations, opposé au premier côté.

Le module est de préférence destiné à être interconnecté électriquement avec des bornes d'interconnexion disposées dans un corps-support de dispositif.

L'invention concerne particulièrement un dispositif à puce électronique tel une carte à puce comportant un tel module. Un tel dispositif peut comporter des composants électroniques divers tels que par exemple un afficheur, un clavier, une batterie, etc. ; Ces dispositifs peuvent générer des fonctions telles que génération d'un numéro à usage unique (OTP), permettre d'afficher les dernières transactions bancaires effectuées, tout en associant des fonctions standard de type paiement, transport, identification...

L'invention concerne également le domaine des supports électroniques tels que cartes à puce à contacts et/ou sans-contact ou cartes hybrides, tickets ou étiquettes radiofréquences, transpondeurs radiofréquences, inserts (ou inlay) intégrant ou constituant un tel module.
De tels supports ou dispositifs à puce électronique peuvent être conformes notamment au standard ISO / IEC 14443 ou ISO 78016.

Les termes « circuit électrique » signifient tout ou partie d'éléments conducteur de courant électrique notamment des plages de contacts électriques, des pistes conductrices, des connexions, des pistes de redirection, des plots électriques associés ou non à au moins un circuit intégré ou composant électronique / électrique (capacité, bobine, résistance...) connecté à ce circuit électrique. Les puces de circuit intégré sont celles connues du domaine de la carte à puce, notamment puce à interface duale (contact et sans contact), diode électroluminescente, capteur audio, microcontrôleur, contrôleur de communication notamment de champ radiofréquence de proximité NFC (Near field communication)

### Art antérieur.

Le brevet US 5 598 032 décrit un procédé d'assemblage d'un module destiné à se connecter à une antenne noyée dans un corps support de carte à puce hybride (contact et sans contact), il est connu de ménager une cavité dans le corps support de manière à rendre les plages de connexion de l'antenne accessibles pour une connexion avec le module lors de son report dans la cavité. Des éléments d'interconnexion conducteurs de toute sorte peuvent relier des zones de connexion du module disposées en dehors de l'enrobage et les plages de connexion de l'antenne.

Par ailleurs, il est connu de fabriquer un module de carte à puce par les étapes ci-après.
- réalisation de pistes ou plages conductrices (ou métallisations) sur les deux faces opposées d'un support continu diélectrique ou isolant,
- report et fixation par sa face arrière d'au moins une puce de circuit intégré sur le support ou les plages,
- connexion, notamment par fil soudé, de la puce à des plages conductrices de contact disposées sur une face externe du module et à des plages d'interconnexion disposées sur une face interne du module,
- enrobage d'au moins la puce et/ou ses connexions par une résine de protection dans une zone d'enrobage autour de la puce,
- dépôt de colle conductrice sur ces plages d'interconnexion pour connexion à une antenne disposée dans un corps de carte,
- découpe et report du module dans une cavité du corps de carte de manière à connecter des bornes d'interconnexion disposées dans le corps de carte appartenant notamment à une antenne radiofréquence.

### Problème technique.

Les modules double face utilisés dans les cartes à puce de type hybride (contact et sans-contact) nécessitent des métallisations onéreuses, notamment par gravure électrochimique, sur les deux faces principales opposées d'un film support diélectrique.

### Résumé de l'invention.

L'invention propose dans un mode de réalisation préféré d'utiliser et de configurer / adapter un module métallisé simple face pour réaliser des zones d'interconnexion.

Le module peut connecter des bornes d'interconnexion disposées notamment dans un corps-support via ces zones d'interconnexion formées selon l'invention.

L'invention a donc pour objet un procédé de fabrication d'un module à puce électronique comprenant des métallisations accessibles de l'extérieur d'un premier côté des métallisations et une puce de circuit intégré disposée du second côté des métallisations, opposé au premier côté, caractérisé en ce qu'il comprend l'étape de formation d'éléments d'interconnexion électrique (9C, 19C, 30), distincts des métallisations, reliant directement la puce et disposés du second côté des métallisations.

Autrement dit, les éléments d'interconnexion peuvent s'étendre ou passer sur / au dessus / le long d'une zone d'interconnexion « Z».

Ainsi, l'invention permet de s'affranchir d'un module double face. Des éléments d'interconnexion reliant directement la puce sont quant même formés du côté de la seconde face du module (face cachée) mais avec une technologie de connexion / redirection beaucoup plus économique tel que le fil soudé.

D'autres caractéristiques et mode de mise en œuvre du procédé font l'objet des revendications 2 à 7.
- En particulier, les éléments d'interconnexion s'étendent en dehors de la périphérie du module et en ce que ces éléments sont sectionnés ultérieurement ;
- une extrémité de ces éléments d'interconnexion (notamment sous forme de fils) peut connecter directement par soudure un plot de la puce tandis que l'autre extrémité est soudée sur des plages conductrices métalliques(ou métallisations) situées hors de la limite du module, à travers un orifice (ou puits de connexion) ménagé dans un substrat diélectrique support des métallisations.
- Le procédé comporte une étape de d'enrobage au moins partiel de la puce par une matière d'enrobage et/ou adhésive à l'exception d'au moins une portion des éléments d'interconnexion ;
- Le procédé comporte une étape de formation de plots d'interconnexion en matière conductrice dans la zone d'interconnexion (Z) de manière à emprisonner/contacter électriquement une portion d'au moins un élément d'interconnexion ;
- Le procédé comporte une étape de sectionnement de l'élément d'interconnexion au cours de l'étape d'extraction / découpe du module du ruban ;

Ainsi, l'invention permet de former facilement des éléments d'interconnexion suffisamment rigides / stables mécaniquement pour leur maintien en position dans une zone d'interconnexion Z avant connexion.

L'invention a également pour objet un procédé pour la fabrication d'un dispositif électrique et/ou électronique, ledit dispositif comportant un corps-support et le module obtenu selon l'une des revendications précédentes, fixé au corps-support ; il est caractérisé en ce qu'il comprend les étapes suivantes de :
- formation d'un corps-support ayant lesdites bornes d'un second circuit accessibles dans / sur le corps-support,
- report du module sur le corps-support, un premier circuit du module connectant lesdites bornes du second circuit.

L'invention a également pour objet un module et dispositif correspondant au procédé.

En particulier, il a pour objet un module à puce électronique comprenant des métallisations accessibles d'un premier côté des métallisations et une puce de circuit intégré disposée du second côté des métallisations, opposé au premier côté, caractérisé en ce qu'il comprend l'étape de formation d'éléments d'interconnexion électrique (9C, 19C, 30), distincts des métallisations, reliant directement la puce et disposés du second côté des métallisations.

Il a aussi pour objet un module à puce électronique comprenant des plages de contact électrique accessibles sur une première face d'un substrat diélectrique et une puce de circuit intégré du côté d'une seconde face opposée à la première face,
caractérisé en ce qu'il comprend des éléments d'interconnexion électrique reliant la puce et s'étendant sur / au-dessus, le long de la seconde face du substrat.

Le dispositif peut constituer de préférence une carte à puce intégrant l'un des composants tels que : un afficheur avec ou sans son circuit de pilotage, un capteur d'empreinte digitale, un capteur d'une autre grandeur physique (rayonnement, température, analyse chimique...), une source d'énergie (cellule solaire, élément de collecte d'énergie, batterie primaire ou rechargeable...),
Le facteur de forme de la carte peut être celui d'une carte ID0, d'un Plug-in UICC, d'un passeport électronique, d'un ticket d'épaisseur inférieure à 0.8 mm.

Brève description des figures.
- Les figures 1 et 2 illustrent un module de carte à puce de l'art antérieur respectivement en vue de dessus et en coupe ;
- Les figures 3 et 4 illustrent une étape de réalisation d'un module conformément à un mode de mise en œuvre du procédé de l'invention selon deux variantes ;
- La figure 5 est une vue en coupe partielle d'un module illustré à l'une des deux figures précédentes ;
- Les figures 6 et 7 illustrent une étape de dépôt de matière conductrice d'interconnexion sur les modules des figures 3 et 4 ;
- Les figures 8 et 9 illustrent respectivement une étape de dépôt de matière conductrice d'interconnexion et une étape de découpe / extraction du module d'un ruban support selon un mode de mise en œuvre préféré du procédé de l'invention.
- Les figures 9A et 10 illustrent deux variantes de formation d'éléments d'interconnexion ;
- La figure 11 illustre un report et connexion du module à des bornes d'interconnexion disposées dans un corps-support ;
- La figure 12 illustre une variante de réalisation d'éléments d'interconnexion avec des lames flexibles conductrices ;
- Les figures 13 et 14 illustrent respectivement le dépôt de matière conductrice sur des portions terminales de pistes conductrices dans une cavité d'un corps support avant un report et connexion d'un module selon un autre mode d'interconnexion électrique.

### Description.

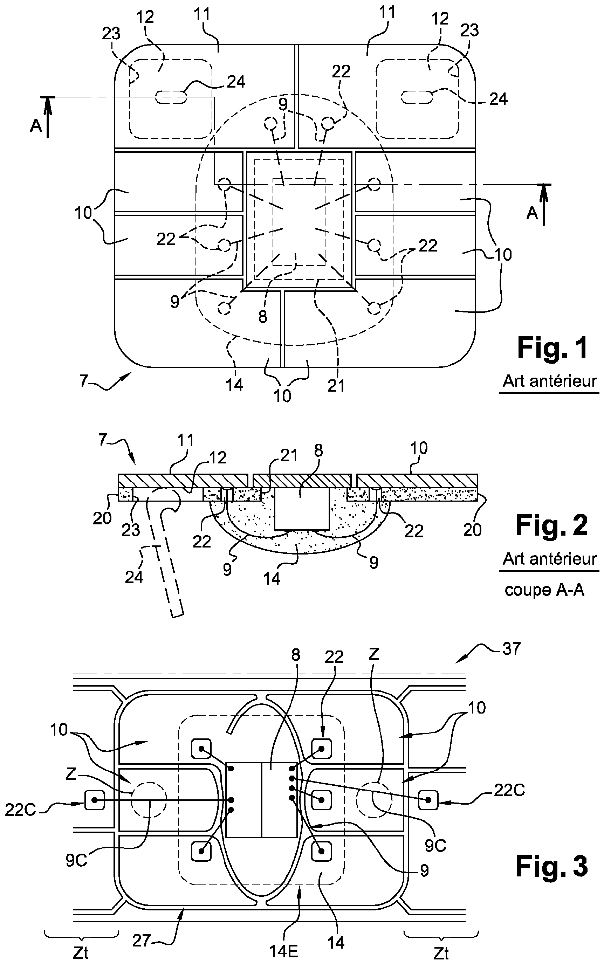

Les figures 1 et 2 illustrent un module 7 de carte à puce de circuit intégré hybride de l'art antérieur. Il comprend des plages de contact 10, 11 sur un support 20 diélectrique ou isolant notamment du type LFCC (Lead frame contrecollé), au moins une puce de circuit intégré 8 reportée sur le support 20 ou ici sur une plage métallique de contact ou non. Les plages de contact sont destinées à connecter un connecteur de lecteur de carte à puce.

Le module comprend également des connexions 9 pour notamment connecter des plages de contact par fils soudés, par colle conductrice ou autre, une puce pouvant être retournée (flip-chip) ou non ; Il comprend un enrobage de la puce et/ou de ses connexions par une matière de protection 14 telle une résine (glob-top), qui peut être déposée par exemple sous forme de goutte ou déposée par surmoulage.
Les connexions 9 connectent les plages de contact à travers des orifices 22 ménagés dans le support isolant.

La surface inférieure du module s'étendant sensiblement du bord de l'enrobage jusqu'au bord du module peut constituer une surface de collage du module sur un plan d'une cavité ménagée dans le corps de carte.

Le module comprend également des moyens de connexions 24 pour connecter une antenne noyée dans un corps de carte (non représenté) recevant le module. Ces moyens 24 connectent deux plages conductrices 11 du module à travers deux orifices 23 situés dans la surface de collage du module sur le corps de carte ou du moins en dehors de la matière de protection 14. Ces deux plages 11 sont connectées aux plots radiofréquences de la puce, ici par fils soudés à travers des orifices 23.

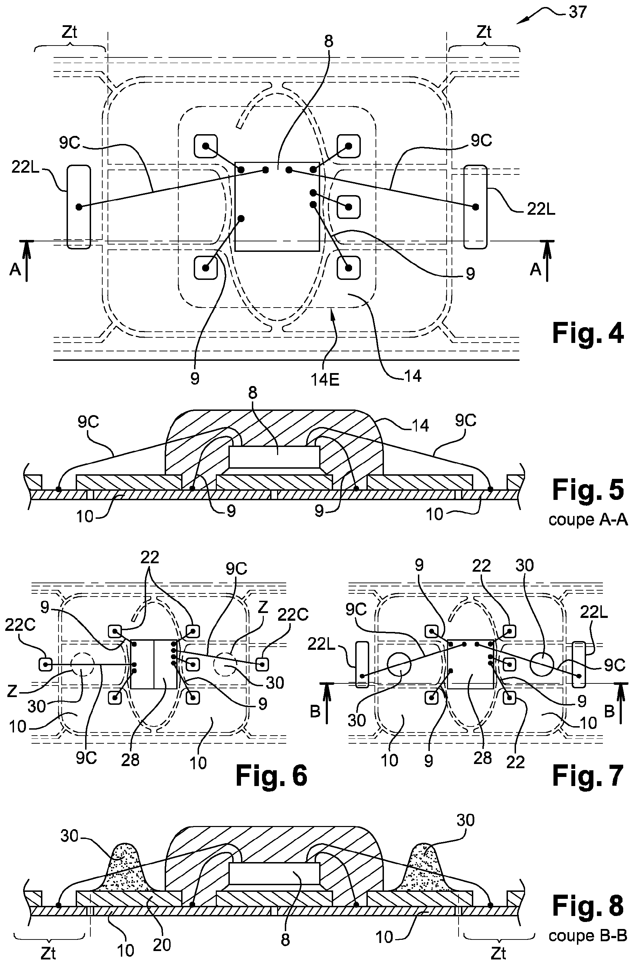

Les figures 3 et 4 illustrent une étape de réalisation d'un module 27 à puce 8 selon ce premier mode de mise en œuvre à deux variantes.

Selon une caractéristique d'un mode préféré de fabrication d'un dispositif comprenant un module (17) à puce électronique conforme à l'invention, le procédé comprend une étape de réalisation de métallisations (ou plages de contact électrique) accessibles d'un premier côté des métallisations. Ici des métallisations sont réalisées sur une première face d'un substrat diélectrique ; Le procédé comprend aussi une étape de report d'une puce de circuit intégré du second côté des métallisations, opposé au premier côté. Les éléments peuvent s'étendre sur / au dessus / le long des métallisations (cas de métallisations sans diélectrique ou métallisations supportées par un diélectrique ajouré au niveau des plages de contact, les métallisations étant derrière le substrat diélectrique du côté de la puce destinée à être enfouie dans un corps de carte). Lorsqu'un substrat diélectrique est présent, les éléments d'interconnexion peuvent s'étendre le long / sur / au dessus du diélectrique du second côté opposé au premier côté des métallisations. Donc, les éléments peuvent s'étendre sur/ au dessus / le long des métallisations ou d'un substrat diélectrique selon le cas.

Ici dans l'exemple, la puce est disposée du côté d'une seconde face de diélectrique opposée à la première face. La puce est en principe connectée aux plages de contact (ou métallisations) par fils soudés.

Les mêmes références d'une figure à l'autre indiquent des moyens identiques ou similaires. Le module est formé sur un ruban 37 de film diélectrique isolant comportant des métallisations définissant une pluralité d'emplacement de modules. Les métallisations sont contrecollées ou gravées de manières connues sur une face du diélectrique. Alternativement, le module peut être formé sur une plaque de film diélectrique au lieu d'un ruban.

Le module 27 à puce à circuit intégré ou électronique 8, peut être sensiblement du même type que sur les figures précédentes à l'exception d'éléments d'interconnexion s'étendant de la puce vers la périphérie du module et distinct de la première métallisation.

Il comprend ici un substrat 20 et de préférence une matière de protection 14 enrobant au moins partiellement le circuit électronique 28 dans une zone d'enrobage 14E. La zone d'enrobage 14E est entourée par une surface périphérique 14C de fixation du module ou de collage.

La puce électronique 28 connecte des plages de contact 10 à travers des orifices 22 par tout moyen connu et en l'occurrence par des fils soudés.

La puce 8 réalise de préférence des fonctions de communication avec un lecteur à contact et sans-contact. Elle comprend des plots pour une communication à contacts type ISO 7816 et deux plots pour une communication sans-contact.

Toutefois, la puce peut réaliser une interconnexion avec un circuit autre qu'une antenne disposé dans un corps-support tel un afficheur, un clavier, un interrupteur...

La puce est montée ici normalement sur le module en ayant sa face arrière fixée sur le module comme à la figure 1. Sa face active portant ses plots de connexion électrique, est orientée vers l'extérieur du module.

Dans une variante de l'invention, on pourra envisager l'absence de substrat 20, les plages ou métallisations étant alors maintenues ensemble via un enrobage ou une résine.

Selon une caractéristique, le procédé comprend l'étape de formation d'éléments d'interconnexion électrique (9C, 19C, 30) reliant la puce et s'étendant sur / au-dessus de la seconde face du substrat ou des métallisations sans connecter électriquement les métallisations au moins dans la zone de collage du module (située en périphérie de l'enrobage).

Dans l'exemple, figures 3 et 4, les éléments d'interconnexion selon le mode préféré, sont réalisés sous forme de fil soudés conducteurs 9C. Une extrémité de ces fils connecte directement par soudure un plot de la puce 8 tandis que l'autre extrémité est soudée sur des plages de contact (ou métallisations) situées hors de la limite du module 27, à travers un orifice (ou puits de connexion) 22C, 22L ménagé dans le substrat diélectrique. Les puits de soudure allongés 22L permettent d'utiliser une plus grande variété de configuration de plots de puce.

Selon une caractéristique d'un mode de mise en œuvre, les éléments d'interconnexion 9C, 19C s'étendent en direction ou en dehors de la périphérie 27 du module ; ces éléments d'interconnexion sont sectionnés ultérieurement notamment à la découpe du module hors de son ruban 37 support de bobine.

Dans l'exemple, les fils soudés 9C des plots sans-contact s'étendent au-delà de la limite finie du module 27 pour être soudés dans des puits 22C situés en dehors de la limite du module. Cette zone Zt en dehors de la zone de module 27 correspond à une zone de travail ou d'amenée de courant propre au ruban 37 de module.

Selon une caractéristique préférée, le procédé peut comporter une étape d'enrobage au moins partiel de la puce, avec une matière d'enrobage, à l'exception d'au moins une portion des éléments d'interconnexion (s'étendant dans la zone Z d'interconnexion).

Dans l'exemple, aux figures 3-5, la puce et ses connexions filaires 9 de type contact sont enrobées. De même sont enrobées les portions de départ des fils de communication sans contact 9C. La portion résiduelle s'étendant de la résine d'enrobage jusqu'aux puits d'attente 9C n'est pas enrobée par de la résine d'enrobage isolante.

Selon une autre caractéristique du mode préféré, le procédé peut comporter une étape de formation de plots d'interconnexion 30 en matière conductrice dans la zone d'interconnexion de manière à emprisonner/contacter électriquement une portion d'au moins un élément d'interconnexion 9C, dans la zone d'interconnexion Z.

Dans l'exemple, aux figures 6 et 7, on effectue un dépôt d'au moins une goutte de matière conductrice 30 comprenant notamment des particules en argent au dessus de chaque fils conducteur 9C. Chaque goutte forme un plot reposant sur le substrat diélectrique 20 et s'étendant en hauteur en emprisonnant et contactant chaque fil conducteur 9C.

Les puits 22C ou 22L ont donc pour fonction de fixer les fils 9C provisoirement en position dans la zone d'interconnexion, au moins pendant l'étape d'enrobage ou au moins pendant la formation des plots conducteurs. Une fois l'enrobage effectué ou au moins le plot conducteur 30 formé, les fils conducteurs 9C sont maintenus mécaniquement sensiblement en position sur une trajectoire passant par une zone d'interconnexion « Z ».

En effet, au cours des manipulations des rubans 37 pendant la fabrication, il se peut que les fils conducteurs 9C non tenus mécaniquement se déplacent dans des positions non souhaitées sous l'effet des mouvements ou vibrations engendrés par le déplacement des modules d'un porte opératoire de fabrication à un autre.

Comme indiqué, on peut pallier ce problème en multipliant les fils soudés sur un même plot et en plaçant plusieurs parcours de fils dans la zone d'interconnexion « Z ». On augmente ainsi les chances de maintenir au moins un fils dans la zone d'interconnexion « Z ». La multiplication des fils sur un même plot de puce permet aussi d'améliorer le contact électrique avec les particules argent des plots 30 de matière conductrice.

Alternativement, de manière générale pour fixer l'extrémité (à priori libre) des éléments d'interconnexion, dans le cas ou un adhésif d'encartage est déposé sur le module au moins dans la zone de collage du module, les fils ou les éléments d'interconnexion 9C peuvent être maintenu par adhésion à l'adhésif notamment dans la zone d'interconnexion « Z ».

Selon une autre caractéristique du mode préféré, on effectue le sectionnement de l'élément d'interconnexion au cours de l'étape de d'extraction / découpe du module du substrat.

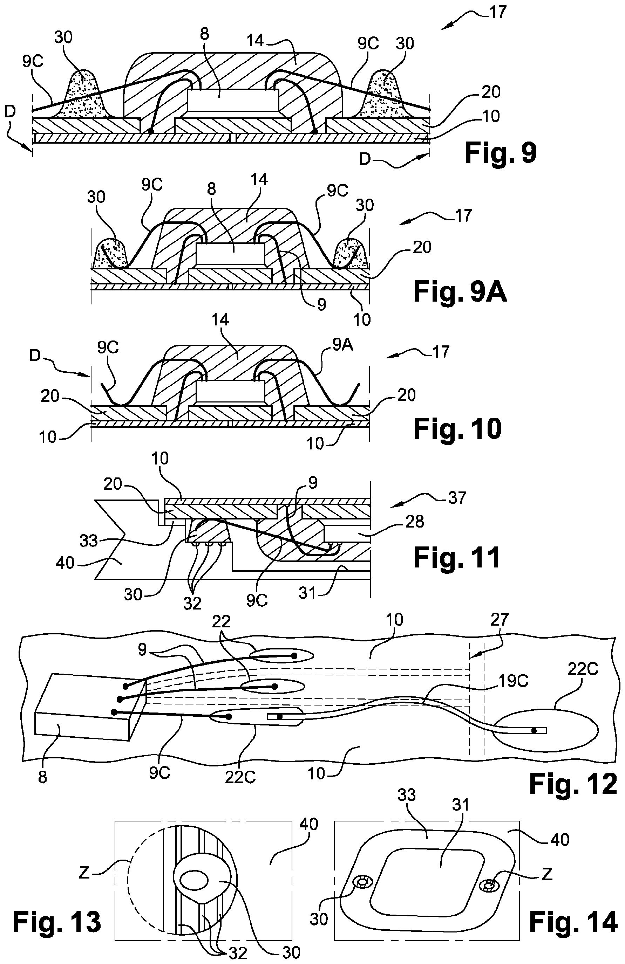

Dans l'exemple, à la figure 9, les fils conducteurs 9C sont sectionnés (ligne pointillée D) lors de l'extraction et report du module.

Alternativement, à la figure 10, les fils peuvent être sectionnés avant l'extraction du module notamment après formation des plots conducteurs argent (figure 9A).

Alternativement, (figure 10) les fils 9C peuvent être formés de manière à se terminer ou à passer par la zone d'interconnexion « Z » sans pour autant être soudé dans un puits 22C. Avant l'enrobage, les fils subissent une courbure ou inflexion donnée par la machine de soudure de manière à avoir une extrémité avoisinant la surface du substrat isolant.

Le module peut rester ainsi (illustré à la figure 10) avant interconnexion notamment par report dans une cavité d'accueil d'un corps-support ; ou comme illustré à la figure 9A, le module peut également et de préférence recevoir des plots conducteurs d'interconnexion 30 formés par dépôt de matière conductrice. Cela a l'avantage de maintenir en place les fils 9C et de préparer une interconnexion ultérieure.

D'une manière générale, on peut utiliser des fils conducteurs ou des éléments d'interconnexion plus rigides notamment sous forme de lame ou en dédoublant ou triplant les fils 9C sur un même plot (non représenté).

Ainsi par exemple, comme illustré à la figure 12, on peut utiliser des éléments d'interconnexion sous forme de nappe / lame conductrice pour plus de rigidité ou tenue mécanique. Ces nappes conductrices peuvent avoir par exemple de 0,05 mm à 0,5 mm de largeur.
Un ruban conducteur peut être directement soudé sur une pointe conductrice formée sur un plot sans contact de la puce. L'autre extrémité du raban peut être maintenue ne l'air ou être soudée ou fixé en dehors de la zone du module. Un sectionnement de ce ruban fixé en dehors de la zone du module peut intervenir ultérieurement en même temps que la découpe / extraction du module du support continu (lead frame.

A la figure 12, une lame flexible 19C connecte la puce via un premier puits relais de connexion électrique 22C (de préférence situé dans une zone d'enrobage de réception d'une matière (résine) de protection) jouxtant une zone périphérique de collage du module et zone d'interconnexion « Z ». Une lame est soudée par ses extrémités à deux puits 22C (accédant à des métallisations 10) situés respectivement dans la zone 27 du module et en dehors de la zone 27 du module.
Le cas échéant, chaque lame (de section deux à 10 fois plus large que le diamètre d'un fil soudé) peut être directement connectée à un plot de puce. Le plot de la puce est typiquement de dimension 50um à 100µm. Ces lames / rubans sont de dimensions entre 0,1mm à 0,5mm et peuvent être soudées sur une pointe (bump) préalablement réalisé sur le plot. Ainsi la lame conducctrice électrique (ou ruban conducteur électriquement) qui est de plus grande largeur peut connecter ce petit plot.

De préférence, la lame est posée (voire légèrement collée) sur le diélectrique à proximité de la base de la puce. Un fil d'interconnexion peut relier un plot de puce par soudure et chaque lame également par soudure, à la base de la puce. L'autre extrémité de la lame peut être fixée par soudure sur une plage relais ou de travail dans un puits 22C en dehors de la surface du module. Cette extrémité sera par la suite sectionnée avec l'extraction du module pour son encartage.

La connexion du fil soudé à une lame peut être de préférence enrobée de matière d'enrobage 14 pour une meilleure solidité et protection mécanique de l'ensemble. La lame 19C est maintenue en position mécaniquement grâce à l'enrobage 14 et ou une adhésion éventuelle d'une extrémité sur le diélectrique à proximité immédiate de la puce dans la zone 14E.

Ce dernier mode de mise en œuvre évite d'avoir des ilots conducteurs relais dans les puits 22C (source de court-circuit accessibles de l'extérieur) formés dans les métallisations 10.

Alternativement, les fils conducteurs 9C peuvent être fixés sur le substrat diélectrique même par thermo compression ou thermo adhésion. Le substrat peut avoir un revêtement en surface offrant une propriété adhésive pour faire adhérer le fil 9C ou lame 19C.
Ainsi, le fil peut être maintenu en place dans la zone d'interconnexion sans avoir à s'étendre en dehors de la zone 27 du module.

Selon une caractéristique du mode préféré de l'invention, le module est connecté aux bornes de connexion 32 d'un corps-support au cours de la fixation du module dans le corps support 40 (fig.11).

A la figure 11, est illustré le module en position dans une cavité de corps-support en l'occurrence un corps de carte à puce.
Le plot conducteur 30 du module contacte électriquement par déformation élastique, des portions terminales 32 d'un circuit électrique (ici une antenne) situé dans le corps-support 40. La connexion électrique s'effectue par simple report du module dans les cavités 33 et 31. Le module est fixé par un adhésif 33.

L'invention prévoit un procédé pour la fabrication d'un dispositif électrique et/ou électronique comprenant le module décrit précédemment.
Le dispositif peut comporter un corps-support 40 muni d'au moins une cavité 31, 33 ménagée dans le corps-support et le module est fixé dans la cavité.

Au préalable, on peut former un corps-support 40 ayant des bornes d'un second circuit 32 incorporées dans le corps-support et au moins une cavité 31, 32 ménagée au-dessus des bornes de connexion 32 du second circuit de manière à révéler lesdites bornes 32 ou les rendre accessibles ;

Ensuite, on reporte le module dans la cavité, ce qui connecte les bornes du second circuit.

En alternative (fig. 13 et 14), on dépose de la matière conductrice sur des portions terminales 32 du corps-support situées dans une cavité du corps-support 32, 32. Le module reporté dans la cavité 31, 33, peut être conforme à l'une quelconque des réalisations décrites précédemment. Le module comprend des zones d'interconnexion Z comprenant des éléments d'interconnexion conducteurs 9C, 19C, 30 maintenus dans cette zone soit seuls (en étant reliés à la puce), soit par emprisonnement dans un plot conducteur 30 ou une matière d'enrobage déposée à proximité.

L'invention réalise ainsi des zones d'interconnexion « Z » distinctes des métallisations situées sur une première face du module (notamment celles destinées à connecter un lecteur de carte à contacts). Ces zones d'interconnexion utilisent avantageusement des éléments classiques d'interconnexion, notamment fil conducteur 9C, identiques à ceux utilisés pour connecter la puce aux métallisations du module.

La puce peut également être montée en étant retourné (flip chip). Des fils d'interconnexion peuvent être soudés sur des zones métalliques relais ou pistes de redirection situées à proximité de l'emplacement de la puce dans la zone 14E (hors d'une zone de collage du module dans un corps support).
Les fils conducteurs 9C peuvent s'étendre des ces zones relais vers la périphérie du module en restant suspendus en l'air en attente d'une interconnexion avec des portions terminales d'un corps-support.

De préférence, on forme des plots conducteurs 30 emprisonnant ces fils comme précédemment.

Alternativement, on utilise des lames conductrices 19C plus rigides que les fils pour rester en l'air le temps d'une interconnexion ; on peut aussi souder plusieurs 9C fils sur une même zone relais pour faciliter l'interconnexion.

Le cas échéant, en montage normal ou en puce retournée, l'invention prévoit de former une (ou plusieurs) boucle partant d'un plot de puce ou d'une plage relais passant au dessus d'une zone d'interconnexion Z et revenant au point de départ, pour soudure, au plot de puce ou plage relais.
La boucle peut recevoir une matière conductrice sous forme de plot au niveau de la zone Z d'interconnexion.
On réalise ainsi des boucles ou des oreilles issues des plots de puce qui ont l'avantage d'avoir une meilleure tenue mécanique qu'un seul fil avec une extrémité libre en l'air.
La tenue mécanique des éléments d'interconnexion 9C, 19C est importante pour s'assurer d'une bonne connexion électrique (et bon positionnement des éléments d'interconnexion) lors du report et connexion du module à des bornes d'un corps support.

Le cas échéant, l'invention prévoit d'interconnecter le module avec un second circuit formé contre ou sur le substrat isolant 20. Le circuit peut être par exemple, une antenne formée par impression de matière conductrice. Le module n'est donc pas nécessairement encarté dans un corps support.

En alternative, les métallisations peuvent être disposées sur une face ou l'autre d'un film diélectrique. Dans le cas où ces métallisations sont disposées sur une face arrière d'un film support (face destinée à être contre un corps support), des ouvertures permettent d'accéder à ces métallisations.

Le cas échéant, on réalise les éléments d'interconnexion comme précédemment décrit mais on dispose en plus une matière isolante dans la zone d'interconnexion Z pour isoler des métallisations situées à l'aplomb du fil conducteur ou des lames conductrices.

## Revendications

1. Procédé de fabrication d'un module (17) à puce électronique comprenant des métallisations accessibles d'un premier côté des métallisations et une puce de circuit intégré disposée du second côté des métallisations, opposé au premier côté, **caractérisé en ce qu'**il comprend l'étape de formation d'éléments d'interconnexion électrique (9C, 19C, 30), distincts des métallisations, reliant directement la puce et disposés du second côté des métallisations.

2. Procédé selon la revendication précédente, **caractérisé en ce que** les éléments d'interconnexion (9C, 19C) s'étendent en dehors de la périphérie du module et **en ce que** ces éléments sont sectionnés ultérieurement.

3. Procédé selon l'une des revendications précédentes, **caractérisé en ce qu'**une extrémité de ces éléments d'interconnexion connecte directement par soudure un plot de la puce 8 tandis que l'autre extrémité est soudée sur des plages conductrices (ou métallisations) situées hors de la limite du module (27), à travers un orifice (ou puits de connexion) (22C, 22L) ménagé dans un substrat diélectrique.

4. Procédé selon l'une des revendications précédentes, **caractérisé en ce qu'**il comporte une étape de d'enrobage au moins partiel de la puce (8) par une matière d'enrobage (14) et/ou adhésive à l'exception d'au moins une portion des éléments d'interconnexion (9C, 19C, 30).

5. Procédé selon l'une des revendications précédentes, **caractérisé en ce qu'**il comporte une étape de formation de plots d'interconnexion (30) en matière conductrice dans la zone d'interconnexion (Z) de manière à emprisonner/contacter électriquement une portion d'au moins un élément d'interconnexion (9C, 19C).

6. Procédé selon l'une des revendications précédentes, **caractérisé en ce qu'**il comporte une étape de sectionnement de l'élément d'interconnexion (9C, 19C) au cours de l'étape d'extraction / découpe du module (17) du ruban (37).

7. Procédé pour la fabrication d'un dispositif électrique et/ou électronique, ledit dispositif comportant un corps-support (40) et le module (17) obtenu selon l'une des revendications précédentes, fixé au corps-support, **caractérisé en ce qu'**il comprend les étapes suivantes de :
- formation d'un corps-support (2) ayant lesdites bornes (32) d'un second circuit accessibles dans / sur le corps-support,
- report du module sur le corps-support, un premier circuit (8, 30) du module connectant lesdites bornes (32) du second circuit.

8. Procédé selon la revendication précédente, **caractérisé en ce que** l'étape de connexion du module aux bornes de connexion (32) s'effectue au cours de la fixation du module (17) sur le corps-support, les plots (30) connectant lesdites bornes (32) de connexion du corps-support .

9. Module (17) à puce électronique comprenant des métallisations accessibles d'un premier côté des métallisations et une puce de circuit intégré disposée du second côté des métallisations, opposé au premier côté, **caractérisé en ce qu'**il comprend des éléments d'interconnexion électrique (9C, 19C, 30), distincts des métallisations, reliant directement la puce et disposés du second côté des métallisations.

10. Module (17) à puce électronique selon la revendications 8, comprenant des plages de contact électrique (10) accessibles sur une première face d'un substrat (20) diélectrique et une puce de circuit intégré (8) du côté d'une seconde face opposée à la première face,
**caractérisé en ce qu'**il comprend des éléments d'interconnexion électrique (9C, 19C, 30) reliant la puce et s'étendant sur / au-dessus / le long de la seconde face du substrat.

11. Dispositif comprenant le module selon l'une des revendications 9 ou 10.
